# EUROPEAN PATENT APPLICATION

(11) **EP 0 843 508 A2**
(43) Date of publication of application: **20.05.1998**
(21) Application number: 97119687.8
(22) Date of filing: 11.11.1997
(51) Int. Cl.: H05K 3/28, H01L 23/29, H01L 23/373

(54) **Coating circuits to dissipate heat**

(30) Priority: 15.11.1996 US 746701
(71) Applicant: HONEYWELL INC., Minneapolis Minnesota 55408 (US)
(72) Inventor: Heffner, Kenneth H., Largo, Florida 34648 (US); Anderson, Curtis W., Largo, Florida 34644 (US)
(74) Representative: Herzbach, Dieter, Dipl.-Ing.

(57) **Abstract**

Molten droplets (35) of a thermally conductive material (33) are sprayed over a printed circuit board (10) to encase circuit components in a durable shell (28) that improves heat transfer from the components.

## Description

This invention relates to techniques for dissipating heat from printed circuits.

A typical printed circuit board contains circuit components that are soldered to a copper back-plane that provides a path for some heat removal from the components. Heat sinks can be attached to larger components and forced air cooling can be used. In some applications, a plate, made of a thermally conductive material, such as aluminum, may be mounted on the board and connected to the chassis. However, many boards may contain extremely small, delicate circuits. Removing heat from these components is more difficult because of their small size and delicate wire connections. The problem is aggravated where air cooling is not possible, for instance, in spacecraft, which operate in a vacuum and use extremely small circuits to reduce weight.

An object of the present invention is to provide a way to improve heat dissipation from printed circuit boards containing a plurality of circuit components.

According to the invention, a thermally conductive material is deposited completely over the components, thermally bonding them together and creating a large heat conductive and dissipating surface through which heat from the individual components can be radiated and transferred to a heat dissipating surface such as a chassis holding the board. The material is deposited with a thermal spray process that produces molten droplets of the material that solidily on striking the components and the board. The components and board are, in effect, encased in a durable, heat conductive shell that has a large surface area and easily conducts heat from the components.

According to the invention, the material comprises a mixture such as diamond dust aluminum nitride, silicon carbide and a ceramic or glass oxide material as a carrier. The low electrically conductive, high thermally conductive material is carried as mixture in the molten droplets to the printed circuit board's surface.

According to the invention, the coating material may comprise a composite of aluminum oxide, titanium oxide, silicon oxide or a fused ceramic of inorganic oxides and diamond dust, silicon nitride or aluminum nitride.

A feature of the invention is that it substantially increases the power handling capability of a printed circuit board. Another feature, the coating can be applied rapidly, thus inexpensively, it is light and extremely durable.

Other objects, benefits and features of the invention will be apparent from the following discussion of one or more embodiments.

Fig. 1 is an elevation of a bare integrated circuit.

Fig. 2 is a functional diagram of a thermal spray gun that may be used to apply a coating according to the present invention.

Fig. 3 is a simple perspective showing of a circuit board containing a plurality of circuit devices.

Fig. 4 shows the circuit board in Fig. 3 with a thermal coating according to the present invention.

Fig. 5 shows the circuit board in Fig.3 with some of the components coated according to the present invention.

Fig. 6 is a cutaway view of the circuit board coated according to the present invention.

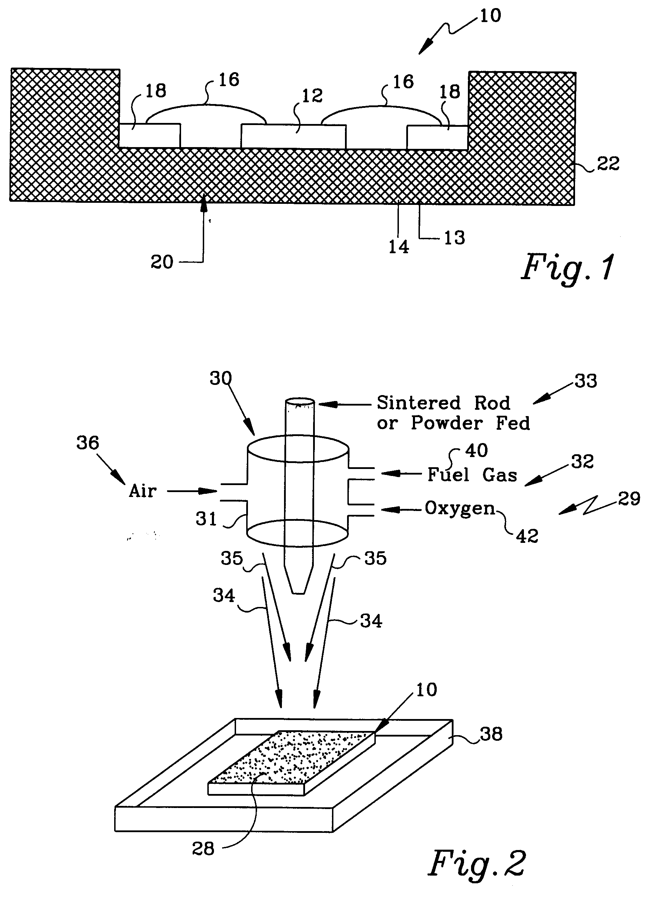

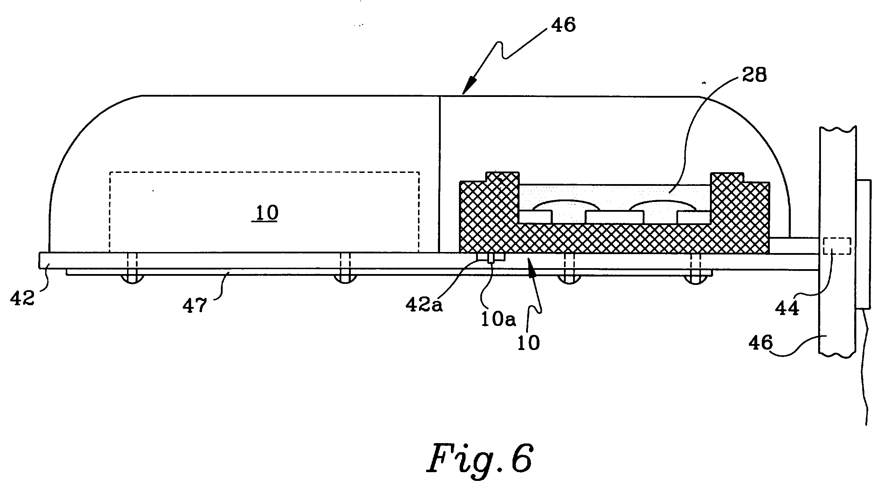

Referring to Fig. 1 an integrated circuit 10 contains a plurality of integrated circuits 12 that are mounted on a substrate 14. Conductors 16 interconnect the circuits 12 and connect the circuits to wire connection pads 18, by which external electrical connections are made to the chips 12. A ceramic package 20 supports the substrate 14. A protective and/or security coating 28 (see Fig. 6) can be applied to the circuit 10 using a thermal spray process. Illustrative apparatus for applying the coating is shown in Fig. 2. The line of sight process uses a thermal spray gun 30 having a nozzle 31. A combustible mixture 32 is applied to the nozzle 31 and ignited. This heats a coating composition 33 that is applied as a wire of sintered rod or powder. The heat melts composition 33, producing molten droplets 35 of the composition. The droplets are propelled towards the circuit 10 by the flame flow from the gun. The droplets splatter on impact with the circuit the droplets cool, forming the coating 28. A desired thickness for the coating is achieved through successive passes over the circuit. Droplet movement can be enhanced by a carrier gas jet 36 of compressed air at a selected rate, e.g., 100 cfm. The coating covers the wires, pads and circuit components. The particle dimensions, torch temperatures and distances are controlled so that the droplets do not overheat the circuit or physically damage the circuit 10 when striking it. A fuel mixture, such as acetylene and oxygen, can be used to produce the droplets or an electric arc or plasma arc can also be used.

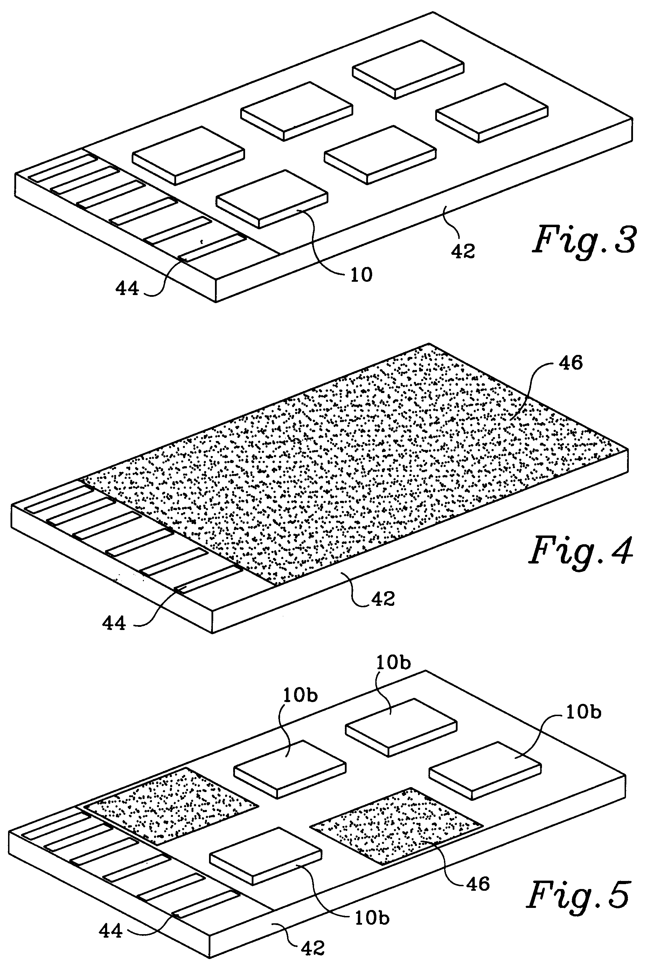

Fig. 3 shows a printed circuit 42 containing a plurality of the circuits 10. Other components (not shown), such resistors, capacitors, inductors, and switches can be assumed to be soldered to the board. Electrical power is applied to the board 42 through a male interconnect edge 44. The circuits 10 are encased in a thermal coating 46, shown in Fig. 4 and in more detail in Fig. 6. Some of the heat generated by a circuit 10 flows through the printed circuit connections from the circuit pins 10a and the copper conductors or vias 42a to which the pins are attached. Some heat is conducted into the surrounding air. But if the circuit is used in a vacuum, for instance, in space craft, this will not take place. Some radiation cooling occurs. The coating 46 thermally bonds the components 10 and the board 40 into a unitary heat conducting capsule. This promotes heat removal through the board interconnect 44 to the chassis 46, through heat radiation and better conduction to a heat conductive medium. The coating is applied through successive passes using a thermal spray process of the type shown in Fig. 2. The coating 46 can overlap the interconnect conductors, as shown, in Fig. 6, which provides a direct conductive path across the entire board to the chassis.

Fig. 5 demonstrates another variation on the invention. Selected circuits 10b can be masked so that they are not coated. This may be beneficial when those circuits do not generate much heat and particular frequency response and signal isolation characteristics, which could be altered by the thermal coating, need to be maintained.

The thermal coating can comprise a mixture, such as diamond dust aluminum nitride, silicon carbide and a ceramic or glass oxide material as a carrier. The low electrically conductive, high thermally conductive material is carried as mixture in the molten droplets to the printed circuit board's surface. The thermal coating may also comprise a composite of aluminum oxide, titanium oxide, silicon oxide or a fused ceramic of inorganic oxides and diamond dust, silicon nitride or aluminum nitride.

Although the present invention has been described with reference to preferred embodiments one of ordinary skill in the art will be able to make modifications and changes, in addition to any already described, in whole or in part to the components and devices described above to carry out the invention without departing from the spirit and scope of the invention.

## Claims

1. A printed circuit board (10), characterized by:
a plurality of circuit components (12); and
a shell (46) of hardened, molten droplets of a thermally conductive material encasing the board and the circuit components.

2. The printed circuit board described in claim 1, further characterized in that:
the material comprises diamond dust.

3. The printed circuit board described in claim 1, further characterized in that:
the material is selected from the group consisting of aluminum oxide, titanium oxide and silicon oxide.

4. The printed circuit board described in claim 1, further characterized in that:
the material comprises fused ceramic of inorganic oxides mixed with a material selected from the group consisting of diamond dust, silicon nitride and aluminum nitride.

5. A method for dissipating heat from a printed circuit board containing circuit components, characterized by:
spraying molten droplets of a thermally conductive material over the board and circuit components to encase the board and the circuit components in a shell of the conductive material.

6. The method described in claim 5, further characterized in that:
the material comprises diamond dust.

7. The method described in claim 5, further characterized in that:
the material is selected from the group consisting of aluminum oxide, titanium oxide and silicon oxide.

8. The method described in claim 5, further characterized in that:
the material comprises fused ceramic of inorganic oxides mixed with a material selected from the group consisting of diamond dust, silicon nitride and aluminum nitride.
